# EUROPEAN PATENT APPLICATION

(11) **EP 0 811 771 A2**
(43) Date of publication of application: **10.12.1997**
(21) Application number: 97114672.5
(22) Date of filing: 25.08.1997
(51) Int. Cl.: F15C 5/00, F04B 43/04, F16K 31/02, F04B 19/00, G01N 1/00, G01N 35/00

(54) **Method for producing an actuator**

(30) Priority: 05.05.1993 DE 4314888
(62) Divisional of application: 94914319.2
(71) Applicant: SIEMENS AKTIENGESELLSCHAFT, 80333 München (DE)
(72) Inventor: Eisele, Ignaz, 82057 Icking (DE); Flietner, Bertrand, 81543 München (DE); Lechner, Josef, 83043 Bad Aibling (DE)

(57) **Zusammenfassung**

Durch Ätzen einer Schicht unterhalb einer Maske, die mit dem Untergrund fest verbunden ist und fest verbunden bleibt und Öffnungen aufweist, entsteht zwischen der Maske und dem Untergrund ein Hohlraum. Die Öffnungen der Maske werden durch eine Abscheidung verschlossen, wodurch die Maske eine dünne Membran mit definiertem Abstand vom Untergrund bildet.

## Description

Die Erfindung bezieht sich auf ein Verfahren zur Herstellung eines Aktuators.

Der für die Strukturierung beim Aufdampfen mit Hilfe von Masken relevante Stand der Technik ist in den Patentschriften AT - PS 241 536, DD - PS 027 798 und US - PS 4 469 719 dargelegt.
Beim SGFET [Patentschrift US 4 411 741] kann die sensitive Schicht entweder elektrochemisch oder durch physikalische [Patentschrift DE 3834189 C1] Methoden wie Aufstäuben oder Aufdampfen abgeschieden werden. Da sich die sensitive Schicht zwischen dem Gate und dem Kanal des Transistors befinden muß, folgen nach dem Aufbringen der sensitiven Schicht mit physikalischen Methoden andere Prozeßschritte wie das Herstellen des Gates oder das Ätzen des Spacers. Diese Schritte können die sensitive Schicht verändern bzw. nur wenige Materialien sind kompatibel zu diesen späteren Schritten. Dies engt die Wahl der sensitiven Schicht stark ein.

Die Aufgabe besteht darin ein Verfahren zur Herstellung eines Aktuators anzugeben.
Diese Aufgabe wird durch die Verfahren nach Anspruch 1 gelöst.

Durch das hier vorgestellte Verfahren des Abscheidens durch eine Maske, die auch das Gate bildet, können alle Materialien als sensitive Schicht verwendet werden, die durch gerichtete Abscheidung wie Aufstäuben oder Dampfen aufgebracht werden können. Diese Schichten müssen zu keinem Ätzschritt kompatibel sein, da die sensitive Schicht als letztes aufgebracht wird.

In Bild 1 ist ein SGFET, der das neue Verfahren des Abscheidens der chemisch sensitiven Schicht erlaubt, schematisch dargestellt. Über dem Kanal (2) zwischen Source (1) und Drain (3) befindet sich eine dünne Schicht aus Siliziumdioxid und darauf eine aus Siliziumnitrid (im Bild nicht näher bezeichnet). Darauf wird Siliziumdioxid (4), dann Siliziumnitrid (5) und schließlich Metall (6) abgeschieden. Das Metall bildet das Gate und die Nitridschicht stellt eine Passivierung der unteren Metalloberfläche dar. Diese ist sinnvoll um möglichst nur die Reaktion der sensitiven Schicht mit dem Sensor zu messen, da dieser grundsätzlich die Änderung der Austrittsarbeitsdifferenz der Materialien ober- und unterhalb des Hohlraumes anzeigt. Dann wird ein Photolackschritt durchgeführt, so daß ein Durchätzen der Nitrid/Metall-Schicht strukturiert erfolgen kann. Nach diesem Schritt wird die dicke Oxidschicht naßchemisch durch die Löcher in der Maske geätzt und so das Siliziumdioxid über dem Kanalbereich des Transistors entfernt. Die Nitridschicht und das Metall (z.B. Platin) werden hierbei nicht geätzt. Durch die Wahl des Nitrid/Siliziumdioxid Schichtsystems wird die Herstellung eines definierten Hohlraumes gewährleistet, da hierfür selektive Ätz- und definierte Abscheidemethoden zur Verfügung stehen. Auf die Struktur kann jetzt in einem letzten Schritt die chemisch sensitive Schicht (7) abgeschieden werden. Dabei müssen die Stegbreite und die Hohlraumhöhe in der gleichen Größenordnung liegen, und die Steghöhe darf höchstens die Größe der Lochbreite besitzen, damit auch die Fläche direkt unter den Stegen bedeckt wird. Oder anders ausgedrückt: Der Kernschatten (8) der Maskenteile über dem Transistorgebiet darf nicht bis auf das Substrat reichen.
Dieses neue Verfahren zur Herstellung des SGFET hat folgende Vorteile:
1. Die Beschichtung ist keinem weiteren Prozeßschritt ausgesetzt und wird so nicht mehr verändert, bzw, es können Materialien benützt werden, die von einem weiteren Prozeßschritt zerstört werden würden.
2. Es können Materialien benützt werden, die in der Halbleitertechnologie normalerweise nicht verwendet werden, da sie Fertigungsanlagen für sonst nachfolgende Prozesse in unzulässigerweise verschmutzen würden.
3. Da alle Herstellungsschritte bis zur letzten Beschichtung für unterschiedliche Materialien identisch sein können, lassen sich auch kleine Stückzahlen für ein bestimmtes sensitives Material kostengünstig herstellen.

Für einen Gassensor, gibt es zwei sinnvolle Verbindungen zu dem zu vermessenden Gasvolumen. Erstens eine möglichst kurze Gaszuführung mit großem Querschnitt um den Sensor schnell den aktuellen Konzentrationen auszusetzen. Zweitens eine lange Gaszuführung mit kleinem Querschnitt um eine bestimmte chemisorbierte Oberflächenbedeckung der sensitiven Schicht zu erhalten, Laufzeiteffekte auszunutzen oder Ventile und Pumpen anschließen zu können. Beide Arten der Gaszuführung sind mit dem hier vorgestellten Sensor möglich. Eine kurze Gaszuführung mit großem Querschnitt läßt sich durch eine offengebliebene Maske verwirklichen. Das zu vermessende Gasvolumen beginnt unmittelbar oberhalb der Maske. Mit dieser Technik läßt sich auch eine Gittermaske über Gassensoren, die auf anderen Meßmethoden beruhen, wie z. B. Leitfähigkeits- und kapazitive Sensoren mit Interdigitalstrukturen, herstellen. Diese Maske dient dann als Schutz gegen Partikel, wobei die maximale Größe der durchkommenden Partikel durch die Löchergröße gegeben ist.
Eine lange Gaszuführung mit kleinem Querschnitt kann folgendermaßen erreicht werden. Die Maske über dem Hohlraum wird verschlossen. Dies kann dadurch geschehen, daß das Aufbringen der sensitiven Schicht relativ isotrop erfolgt und so nicht nur eine Schicht auf den Isolator über dem Kanal abgeschieden wird, sondern auch die Löcher in der Maske langsam zuwachsen. Dies ist in Bild 2 dargestellt. Die im aktiven Bereich weggeätzte Siliziumdioxidschicht (1) und die Nitrid/Metall-Schicht (2) sind hergestellt wie oben beschrieben. Dann wird soviel chemisch sensitives Material (3) abgeschieden, daß die Löcher in der Maske geschlossen werden. Hierfür ist eine große Steghöhe im Verhältnis zur Lochbreite günstig. Sowohl schattenfreies Abscheiden unter die Maske als auch Verschließen der Löcher in einem Schritt ist möglich, wenn sowohl Stegbreite und Hohlraumhöhe als auch Steghöhe und Lochbreite jeweils in der gleichen Größenordnung liegen.
Die Maske kann auch in einem zusätzlichen Schritt verschlossen werden, bei dem ein Material unter einem so flachen Winkel aufgebracht wird, daß dieses die Maske nicht durchqueren kann, d.h. nicht auf die sensitve Schicht abgeschieden wird, und so die Löcher der Maske verschließt.
Dies ist in Bild 3 dargestellt. Der Aufbau kommt wie für Bild 1 beschrieben zustande. Es sind: Siliziumdioxid (1), Nitrid (2), Metall (3). Nach der chemisch sensitiven Schicht (4) wird jetzt ein Material (5) unter sehr flachen Winkel zum Verschließen der Löcher abgeschieden. Die ideale Quelle für dieses Verfahren ist ringförmig. Falls die Quelle ungefähr punktförmig ist, ist ein Drehen der Sensorstrukur in der Maskenebene hilfreich. Unabhängig davon mit welcher Methode die Maske verschlossen wurde, kann anschließend Klebstoff oder eine aushärtende Flüssigkeit als mechanischer oder chemischer Schutz aufgebracht werden. Der Anschluß an das zu vermessende Gasvolumen erfolgt folgendermaßen. Die Metall/-Nitrid-Maske wird lateral derart strukturiert (in Bild 5 dargestellt), daß Gaskanäle (2 ein Gaskanal) von dem Gasvolumen über dem Transistorgebiet (1) wegführen. Den vertikalen Aufbau eines solchen Gaskanales zeigt Bild 4. Auf dem Substrat (1) wird, wie bei der Herstellung des SGFET bereits beschrieben, erst eine Siliziumdioxidschicht (2) aufgebracht, dann eine Nitrid- oder Nitrid/Metall-Schicht (3) und diese strukturiert. Eine Metallschicht ist nicht notwendig, stört jedoch auch nicht und kann mitaufgebracht werden um die Gesamtzahl der Photoschritte möglichst klein zu halten. Nach dem naßchemischen Herausätzen der Oxidschicht wird soviel Material (4) abgeschieden, daß dieses Material von der unteren bis zur oberen Nitridschicht reicht und so das Loch in der Maske verschließt. Es verbleiben die Gaskanäle (5). Ein möglichst senkrechtes Abscheiden des Materials (4) wäre hier günstig, ist jedoch nicht notwendig, wenn die obere Nitridschicht (3) hinreichend stark unterätzt ist.
Auch die Verfahren zum Verschließen des Hohlraumes über dem Transistor eignen sich zum Herstellen von Gaskanälen, sind auf der einen Seite etwas komplizierter, da dort das Material nicht die untere Nitridmaske mit der oberen verbinden darf, auf der anderen Seite können die gleichen Prozeßschritte angewandt werden.

Die mit den neuen Methoden hergestellten Membranen werden nicht nur passiv ausgelenkt, sondern können auch aktiv ausgelenkt werden. Hierfür gibt es z. B. folgende Möglichkeiten:
1. elektrostatisch; Sind sowohl die Membran, als auch der Untergrund elektrisch leitfähig und nicht miteinander kurzgeschlossen, so kann durch Anlegen einer elektrischen Spannung zwischen den beiden der von den beiden Flächen gebildete Kondensator geladen werden. Die ungleichnamigen Ladungen auf den beiden Flächen ziehen sich, gegenseitig an und lenken die Membran zum Untergrund hin aus. Durch gleichnamiges Aufladen der beiden Flächen kann die Membran vom Untergrund abgestoßen werden.
2. magnetisch; Befindet sich der ganze Aktuator in einem Magnetfeld, z. B. durch Anbringen eines Dauermagneten, so wirkt auf einen stromdurchflossenen Leiter auf der Membran eine Kraft, die die Membran auslenken kann. Stromrichtung und -stärke bestimmen mit dem Magnetfeld die Richtung der Auslenkung und die Amplitude.
3. thermische Verspannung; Sind die thermischen Ausdehnungskoeffizienten von Membran und Untergrund verschieden, so kann ein Heizen oder Kühlen des ganzen Aktuators die Membran auslenken. Die Membran kann auch ausgelenkt werden indem ein Temperaturunterschied zwischen Untergrund und Membran erzeugt wird, z. B. durch Heizen der Membran mit einem aufgebrachten Widerstandsdraht. Die erfolgversprechenste Art der thermischen Verspannung stellt eine Bimetallmaske dar, d. h. die Membran selbst besteht aus mindestens zwei Schichten mit unterschiedlichen thermischen Ausdehnungskoeffizienten. Durch Ändern der Temperatur kann die Durchbiegung der Maske eingestellt werden.
Sind die beiden Schichten mit unterschiedlichen thermischen Ausdehnungskoeffizienten Metalle mit unterschiedlicher Fermienergie, d. h. es bildet sich eine Kontaktpotentialdifferenz, so können zwei Membranen und eine Stromquelle zu einer Wärmepumpe (Peltierelement) kombiniert werden. So wird Wärmeenergie von einer Membran zu der anderen mit einem hohen Wirkungsgrad transportiert, d. h. eine Membran wird erwärmt während die andere gekühlt wird. Die Stromrichtung bestimmt welche Membran erwärmt bzw. gekühlt wird. Will man sehr viele Membranen ansteuern, so ist eine variable elektrische Schaltung günstig zur weiteren Optimierung des Wirkungsgrades. In einem Stromkreis sollen immer zwei Membranzustände, wobei jeder Zustand durch viele Membranen vertreten sein kann, geschalten werden, für die gilt:
1. Ein Zustand soll erwärmt werden und ein Zustand soll gekühlt werden.
2. Die Temperatur der beiden Membranzustände soll möglichst gleich sein.

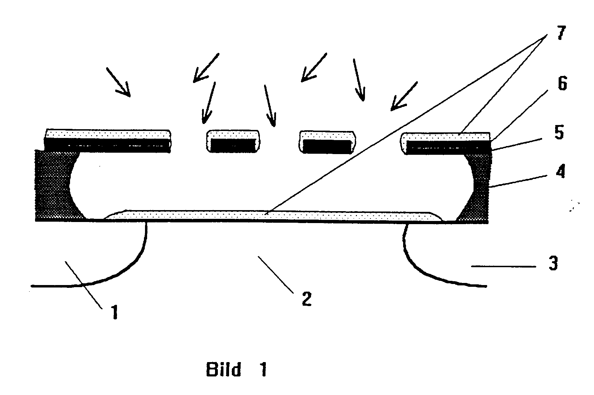

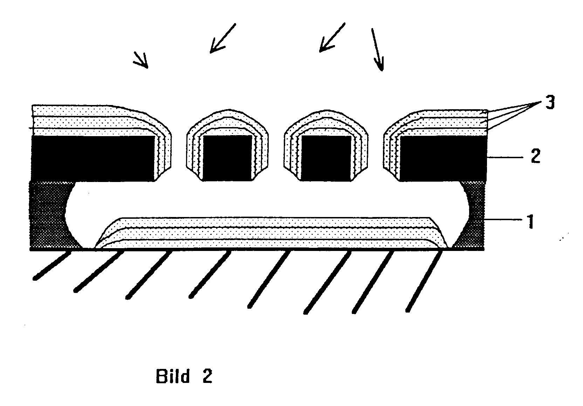

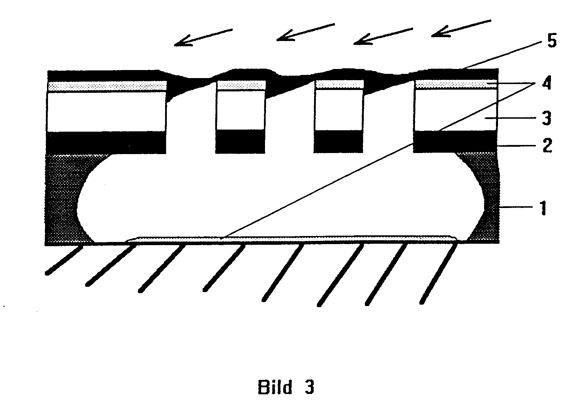

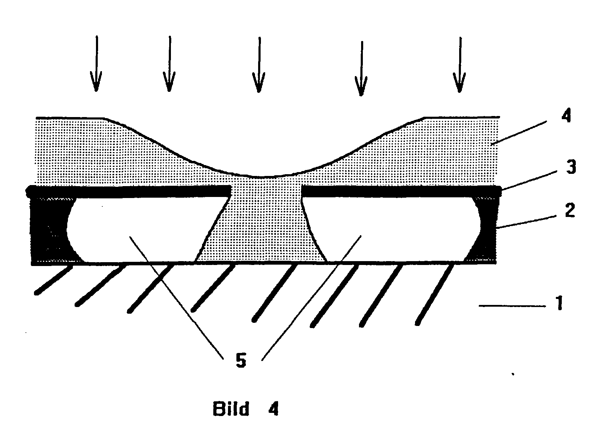

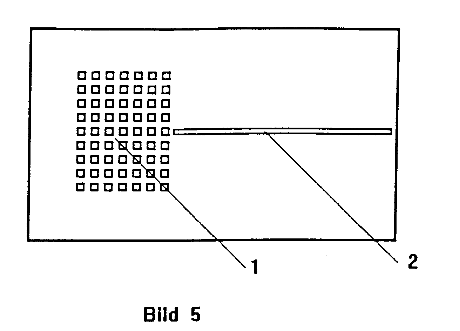

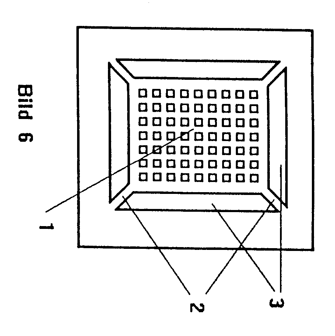

Durch Auslenkung der Membran wird das Volumen des Hohlraums verändert. Schließt man mehrere derartige Hohlräume durch Mikrokapillaren zu einer Reihe zusammen, so kann man durch koordinierte Auslenkung der Einzelmembranen eine Strömung einer Flüssigkeit durch die Hohlräume und Kapillaren erreichen. Das Pumpen von Gasen bleibt jedoch bei ebenen Untergrund schwierig, da der Hohlraum auch bei ganz nach unten gebogener Membran noch ein großes Totraumvolumen besitzt und eine Rückströmung möglich bleibt. Dieses Problem wird folgendermaßen gelöst. Die Maske wird lateral strukturiert, wobei die Öffnungen in Größe und Anzahl über die Membranfläche variiert werden. In Kombination mit der Schichtabscheidung zum Verschließen der Maske soll hierdurch auf dem Untergrund eine Form entstehen, die das Gegenstück zur Membran in der unteren Maximalauslenkung darstellt. In Abbildung 7 ist ein solches Pump- bzw. Ventilstück im Querschnitt dargestellt. Dabei ist (1) der Untergrund, (2) die teilweise weggeätzte Siliziumdioxidschicht, (3) die Maske mit den unterschiedlich großen Öffnungen und (4) das zum Verschließen der Maske abgeschiedene Material, das unterhalb der Maske die Form der durchgebogenen Membran besitzt. In Abbildung 8 ist die laterale Struktur von zwei durch eine Mikrokapillare verbundene Pump- bzw. Ventilstücke vor dem Verschließen zu sehen. Dabei ist (1) die Mikrokapillare und (2) eine Öffnung in der Maske. Viele solcher Pump-/Ventilstücke lassen sich in einer Reihe anordnen und bilden so eine Pumpe oder eine "aktive Gasleitung". Abbildung 9 zeigt oben die laterale Struktur einer solchen aktiven Gasleitung (1 Pump-/Ventilstück, 2 Mikrokapillare) und unten den Querschnitt durch diese Leitung (3 durchgebogene Membran, 4 Membran in Ruhelage). Durch koordinierte Auslenkung der Membranen (Pfeil nach oben und Pfeil nach unten) wird ein abgeschlossenes Gasvolumen in eine bestimmte Richtung geschoben (horizontale Pfeile).

## Patentansprüche

1. Verfahren zur Herstellung eines Aktuators durch Verschließen aller oder mancher Öffnungen einer Maske, die mit dem Untergrund fest verbunden ist und fest verbunden bleibt,
**dadurch gekennzeichnet,**
daß zwischen der Maske und dem Untergrund ein Hohlraum ist, und die Öffnungen durch eine Abscheidung verschlossen werden.

2. Verfahren nach Anspruch 1,
**dadurch gekennzeichnet,**
daß durch das Verschließen der Öffnungen die Maske eine dünne Membran mit definiertem Abstand vom Untergrund bildet.

3. Verfahren nach Anspruch 1,
**dadurch gekennzeichnet,**
daß die Größe und die Anzahl der Öffnungen in der Maske mit der lateralen Anordnung derart variiert wird, daß durch eine geeignete Abscheidung auf dem Untergrund Material in einer Form aufgebracht wird, die in etwa das Gegenstück zur nach unten durchgebogenen Membran bildet.

4. Verfahren nach Anspruch 1,
**dadurch gekennzeichnet,**
daß als Aktuator ein Ventil hergestellt wird.

5. Verfahren nach Anspruch 1,
**dadurch gekennzeichnet,**
daß als Aktuator eine Pumpe hergestellt wird.

6. Verfahren nach Anspruch 1,
**dadurch gekennzeichnet,**
daß als Maske ein Gitter eingesetzt wird.

7. Verfahren nach Anspruch 1,
**dadurch gekennzeichnet,**
daß als Maske eine Schicht mit Wabenstruktur eingesetzt wird.

8. Verfahren nach Anspruch 1,
**dadurch gekennzeichnet,**
daß der Hohlraum durch Ätzen einer Schicht hergestellt wird.

9. Verfahren nach Anspruch 1,
**dadurch gekennzeichnet,**
daß für die zu ätzende Schicht SiO₂ eingesetzt wird.

10. Verfahren nach Anspruch 1,
**dadurch gekennzeichnet,**
daß als Maske strukturiertes Si₃N₄ eingesetzt wird.

11. Verfahren nach Anspruch 1,
**dadurch gekennzeichnet,**
daß auf die Maske vor der Strukturierung eine weitere Schicht abgeschieden wurde.

12. Verfahren nach Anspruch 1,
**dadurch gekennzeichnet,**
daß der Untergrund, über dem die Maske verschlossen wird, bereits strukturiert wurde.

13. Verfahren nach Anspruch 1,
**dadurch gekennzeichnet,**
daß mehrere Einzelaktuatoren ein Gesamtsystem bilden.

14. Verfahren nach Anspruch 1,
**dadurch gekennzeichnet,**
daß mehrere Einzelaktuatoren eine aktive Gasleitung bilden.

15. Verfahren nach Anspruch 1 bis 3,
**dadurch gekennzeichnet,**
daß die hergestellte Membran elektrostatisch ausgelenkt wird.

16. Verfahren nach Anspruch 1 bis 3,
**dadurch gekennzeichnet,**
daß die hergestellte Membran magnetisch ausgelenkt wird.

17. Verfahren nach Anspruch 1 bis 3,
**dadurch gekennzeichnet,**
daß die hergestellte Membran durch thermische Verspannung ausgelenkt wird.

18. Verfahren nach Anspruch 17,
**dadurch gekennzeichnet,**
daß die thermische Verspannung durch Heizen der Membran erzeugt wird.

19. Verfahren nach Anspruch 17,
**dadurch gekennzeichnet,**
daß die thermische Verspannung durch Kühlen der Membran erzeugt wird.

20. Verfahren nach Anspruch 18,
**dadurch gekennzeichnet,**
daß die thermische Verspannung durch eine Wärmepumpe zwischen zwei Membranen erzeugt wird.
